(19) Europäisches Patentamt
European Patent Office
Office européen des brevets

(11) **EP 2 804 220 A2**

(12) **EUROPEAN PATENT APPLICATION**

(43) Date of publication:
**19.11.2014 Bulletin 2014/47**

(51) Int Cl.:
*H01L 31/032* (2006.01)        *H01L 31/0749* (2012.01)
*H01L 31/18* (2006.01)        *H01L 21/02* (2006.01)

(21) Application number: **14161831.4**

(22) Date of filing: **26.03.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **16.05.2013   KR 20130056037**

(71) Applicant: **Samsung SDI Co., Ltd.
Yongin-si, Gyeonggi-do (KR)**

(72) Inventor: **Kim, Hyun-Chul
Gyeonggi-do (KR)**

(74) Representative: **Mounteney, Simon James
Marks & Clerk LLP
90 Long Acre
London
WC2E 9RA (GB)**

(54) **Method of manufacturing thin film solar cell, device for manufacturing thin film solar cell, and thin film solar cell including buffer layer manufactured by the method**

(57)     A device of manufacturing a cascade thin film solar cell with improved productivity, and a thin film solar cell manufactured using the device have been disclosed.

The thin film solar cell having a buffer layer formed by a method using the device has improved electrical characteristics.

## FIG. 3

EP 2 804 220 A2

**Description**

**BACKGROUND**

**1. Field**

Aspects of one or more embodiments of the present invention relate to a method of manufacturing a thin film solar cell, a device for manufacturing a thin film solar cell, and a thin film solar cell including a buffer layer manufactured by the method.

**2. Description of the Related Art**

Recently, as conventional energy sources such as fossil fuels are expected to deplete, there has been a growing interest in alternative energy sources. Among them, solar cells have been spotlighted for use in next generation batteries that directly convert solar energy into electric energy using semiconductor materials.

A solar cell has a basic structure of a diode consisting of PN junctions.

Solar cells, including light absorbing layers made of silicon, may be classified into crystalline (monocrystalline, polycrystalline) substrate solar cells and thin film (amorphous, polycrystalline) solar cells. Also, examples of solar cells may include thin film solar cells including a light absorbing layer made of an S-substituted copper-indium-gallium-selenide (CIGS)-based compound or S-unsubstituted copper-indium-gallium-selenide (CIGS)-based compound, or cadmium telluride (CdTe), III - V group solar cells, dye-sensitized solar cells, and organic solar cells.

Of them, the CIGS-based thin film solar cell may include a cadmium sulfide (CdS) buffer layer or a Cd-free buffer layer from which cadmium (Cd) is eliminated since Cd is harmful to the human body. The Cd-free buffer layer may be formed by Chemical Bath Deposition (CBD).

Of Cd-free buffer layers formed by CBD, a zinc sulfide (ZnS)(O, OH) buffer layer may be generally formed by a method including a wet pretreatment using an alkaline solution, forming a film by reacting an alkaline solution (e.g., ammonia water), a zinc source, and a sulfur source in the same deposition reactor, and washing the film.

As an alternative, the ZnS(O, OH) buffer layer may be formed by a method of forming a PN junction via n-type diffusion using a zinc source, which includes washing off impurities from the surface of a light absorbing layer and substituting a zinc source on a vacancy region while absorbing a zinc source on the surface of the p-type light absorbing layer.

However, each of the methods may form a ZnS(O, OH) buffer layer without fully performing the step of substituting and etching a zinc source on a vacancy region near the surface of the light absorbing layer, or the ZnS(O, OH) buffer layer formed may not be uniform because the diffusion behavior, and distribution of the zinc source vary depending on the crystallinity and composition on the surface of the light absorbing layer. Furthermore, the poor band alignment characteristics between a light absorbing layer and a transparent electrode layer may result in a low open voltage ($V_{oc}$).

Accordingly, there is still a need for the development of a method of manufacturing a thin film solar cell having all the enhancements described above, a device for manufacturing the thin film solar cell, and a thin film solar cell including a buffer layer manufactured by the method.

**SUMMARY**

The present invention provides a method of manufacturing a cascade thin film solar cell as claimed in claims 1 to 8, a device for manufacturing a cascade thin film solar cell as claimed in claims 9 to 14 and a thin film solar cell as claimed in claim 15.

An aspect of an embodiment of the present invention relates to a method of manufacturing a cascade thin film solar cell with improved productivity.

Another aspect of an embodiment of the present invention relates to a device of manufacturing a cascade thin film solar cell.

A further aspect of an embodiment of the present invention relates to a thin film solar cell including a buffer layer formed by the method having improved electrical characteristics.

Aspects of embodiments of the present invention relate to a method of manufacturing a cascade thin film solar cell with improved productivity, a device for manufacturing a thin film solar cell, and a thin film solar cell including a buffer layer with improved electrical characteristics manufactured by the method. Additional aspects will be set forth in part in the description which follows and, in part, will be apparent from the description, or may be learned by practice of the presented embodiments.

In an embodiment of the present disclosure, a method of manufacturing a thin film solar cell includes: supplying an alkaline solution to a substrate disposed inside a first bath and on which a light absorbing layer is formed; washing and etching the substrate inside the first bath; supplying a zinc source and a solution, remaining in the first bath after the supplying of the alkaline solution and the washing and etching of the substrate, to the substrate disposed inside a second bath moved thereto from the first bath; diffusing the zinc source to inside of the light absorbing layer through a surface of the light absorbing layer; supplying a sulfur source and a mixed solution including a solution, remaining in the second bath after the supplying of the zinc source and the diffusing of the zinc source, to the substrate disposed inside a third bath and moved thereto from the second bath; and forming a buffer layer on the substrate with the light absorbing layer.

In another embodiment of the present disclosure, a device of manufacturing a thin film solar cell includes: a first bath configured to supply an alkaline solution to a substrate disposed therein, on which a light absorbing layer is formed; a second bath configured to supply a zinc source and a solution in the first bath to the substrate moved thereto from the first bath; a third bath configured to supply a sulfur source and a solution in the second bath to the substrate moved thereto from the second bath; a first connecting device connected to the first bath and the second bath, and configured to collect the solution in the first bath, and to supply the solution in the first bath to the second bath; and a second connecting device connected to the second bath and the third bath, configured to collect the solution in the second bath, and to supply the solution in the second bath to the third bath.

In a further embodiment of the present disclosure, a thin film solar cell including a buffer layer formed according to the method described above.

According to aspects of embodiments of the present disclosure, a method of manufacturing a cascade thin film solar cell, and a device of manufacturing a thin film solar cell by the method have improved productivity, and a thin film solar cell having a buffer layer formed by the method has improved electrical characteristics.

## BRIEF DESCRIPTION OF THE DRAWINGS

These and/or other aspects will become apparent and more readily appreciated from the following description of the embodiments, taken in conjunction with the accompanying drawings in which:

FIG. 1 is a flowchart illustrating a method of manufacturing a buffer layer for a thin film solar cell, according to an embodiment of the present invention;
FIG. 2 is a flowchart illustrating a method of manufacturing a buffer layer for a thin film solar cell;
FIG. 3 is a schematic diagram illustrating a manufacturing device for forming a buffer layer of a thin film solar cell, according to an embodiment of the present invention;
FIG. 4 is a schematic cross-sectional view illustrating a thin film solar cell according to an embodiment of the present invention; and
FIG. 5 is a schematic cross-sectional view illustrating a thin film solar cell according to another embodiment of the present invention.

## DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list. Further, the use of "may" when describing embodiments of the present invention refers to "one or more embodiments of the present invention."

Hereinafter, a method of manufacturing a thin film solar cell, according to an embodiment of the present description, a device manufacturing a thin film solar cell, and a thin film solar cell including a buffer layer manufactured by the method will be described in more detail. It should be understood that the example embodiments described herein should be considered in a descriptive sense only and not for purposes of limitation. The descriptions of features or aspects within each embodiment should typically be considered as available for other similar features or aspects in other embodiments.

In the figures herein below, each of the constitutional features (or elements) is exaggerated, abbreviated or schematically shown for the purpose of convenience and to clarify the specification of the present invention and the size of each constitutional feature may not entirely reflect the actual size. Furthermore, when an element (a constitutional feature) is referred to as being "on" another element, it can be directly on the other element or be indirectly on the another element with one or more intervening elements interposed therebetween. In addition, when an element (a constitutional feature) is referred as being "over", "upper", "under', or "lower", the "over", "upper", "under', or "lower" indicates that it is indirectly formed "over", "upper", "under', or "lower" with respect to another element, and the standard regarding "over", "upper", "under', or "lower" is explained referring to the figures.

In an embodiment of the present disclosure, a method of manufacturing a thin film solar cell via CBD includes: supplying an alkaline solution to a substrate, which is disposed inside a first bath and on which a light absorbing layer is formed, and washing and etching the substrate with the alkaline solution; supplying a zinc source and a solution remaining (after the act of supplying the alkaline solution) to the substrate, which is disposed inside a second bath once moved thereto from the first bath in the act of supplying the alkaline solution, and diffusing the zinc source to inside of the light absorbing layer through the surface of the light absorbing layer (beyond the surface and into a region near the surface of the light absorbing layer); and supplying a sulfur source and a mixed solution including the solution remaining (after the act of supplying the zinc source) to the substrate, which is disposed inside a third bath and moved thereto from the second bath in the act of supplying the zinc source and the solution remaining after the act of supplying the zinc source, and forming a buffer layer on the substrate with the light absorbing layer.

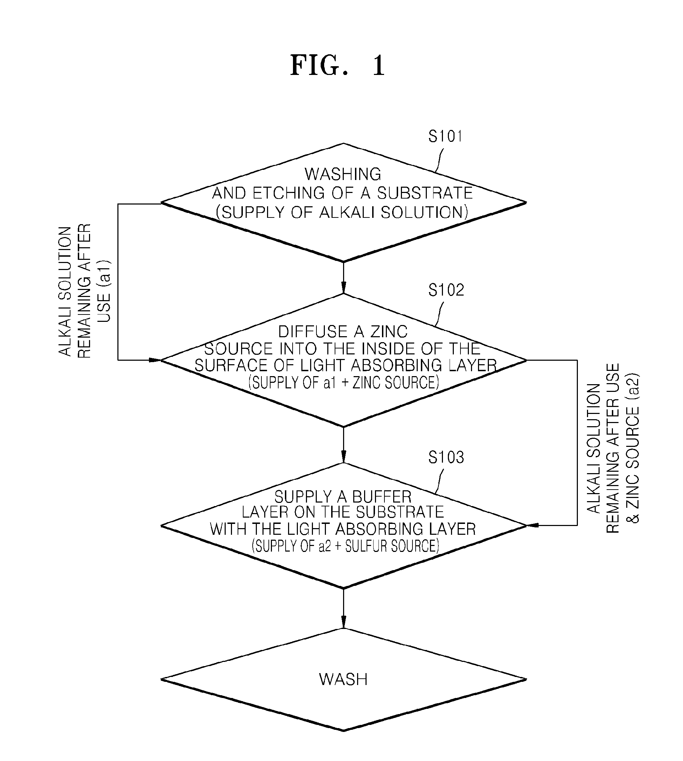

FIG. 1 is a flowchart illustrating a method of manufacturing a buffer layer for a thin film solar cell, according to an embodiment of the present invention.

Referring to FIG. 1, the manufacturing method relates to forming a buffer layer of a cascade thin film solar cell, wherein an alkaline solution remaining after the use in a previous act is reused in diffusing a zinc source to the inside of a surface of a light absorbing layer, and further reused in forming a buffer layer on a substrate (with the light absorbing layer), thereby sufficiently washing off impurities, such as metal materials, and oxides, from the surface of the light absorbing layer.

Further, the zinc source remaining after the use in a previous act is reused in forming the buffer layer on the substrate with the light absorbing layer, thereby sufficiently supplying the zinc source to the vacancy region near the surface of the light absorbing layer, which enables substituting and etching of the zinc source, thus enabling the diffusion and distribution of a sufficient amount of the zinc source on the surface and/or the inside of the surface of the light absorbing layer.

As a result, a sufficient band alignment between the light absorbing layer and a transparent electrode layer is established, and accordingly, the electrical characteristics of a thin film solar cell including a buffer layer, for example, $V_{oc}$, etc., may be improved.

The alkaline solution may preferably include an ammonia compound. For example, the alkaline solution may preferably include ammonia or an aqueous ammonia solution ($NH_4OH$). The alkaline solution is used to wash impurities from a surface of a light absorbing layer by reacting with metal ions present on the surface of the light absorbing layer. Further, the ammonia or aqueous ammonia solution ($NH_4OH$) forms a cuprammonium complex, such as $[Cu(NH_4)_3]^{2+}$ or $[Cu(NH_4)_2]^{2+}$ in $Cu_xSe$ or Cu rich site present on the surface of the light absorbing layer, thereby controlling the shunt path and also improving a band alignment property.

In addition, the ammonia or aqueous ammonia solution can form a ligand by binding to $Zn^{2+}$ of the zinc source, thereby inducing a binding between zinc and the surface of the light absorbing layer, and also enabling control of the rate of forming a buffer layer on the surface of the light absorbing layer.

The zinc source may preferably include a zinc salt or a zinc compound, for example, an aqueous zinc sulfate solution ($ZnSO_4\text{-}7H_2O$). In diffusing the zinc source to the inside of the surface of the light absorbing layer, the solution remaining after the use in the act of supplying the alkaline solution to the substrate may preferably include the alkaline solution. The alkaline solution being reused can effectively remove $Cu_xSe$ material and oxides present on the surface of the light absorbing layer, and thus can sufficiently substitute and diffuse the newly supplied zinc source into the inside of the light absorbing layer, thereby promoting the growth of the buffer layer.

The sulfur source may preferably include a thiourea-based compound. In the forming of the buffer layer on the substrate with the light absorbing layer, the mixed solution remaining after the act of supplying the zinc source and the solution remaining after the use to the substrate may preferably include the alkaline solution and the zinc source. As described above, the alkaline solution and the zinc source being reused are supplied in sufficient amounts so that they can effectively wash off impurities from the surface of the light absorbing layer, and also substitute $Zn^{2+}$ to the vacancy region near the surface of the light absorbing layer, or diffuse into the inside of the light absorbing layer. The newly supplied sulfur source can form a uniform buffer layer on the light absorbing layer.

In the forming of the buffer layer on the substrate with the light absorbing layer thereon, the mixed solution may preferably include about 1 M to about 5 M of the alkaline solution, about 0.01 M to about 0.1 M of the zinc source, and about 0.2 M to about 1.3 M of the sulfur source.

Here, the forming of the buffer layer on the substrate with the light absorbing layer may preferably include immersing the substrate with the light absorbing layer into the mixed solution, followed by heating at a temperature below 70°C. For example, the forming of the buffer layer on the substrate with the light absorbing layer may preferably include immersing the substrate with the light absorbing layer into the mixed solution, followed by heating at a temperature between about 60°C to about 70°C. In an embodiment of the present invention the immersion is for a period of between about 5 minutes and 25 minutes, preferably between about 8 minutes and about 15 minutes.

When the substrate is immersed into the mixed solution of the alkaline solution, the zinc source, and the sulfur source within the above concentration range, and heat-treated in the above temperature range, the buffer layer can be continuously formed on the substrate on which the light absorbing layer is formed, thus enabling reduction in manufacturing cost, and also resolving the environmental issue in handling waste liquids.

The buffer layer formed on the substrate with the light absorbing layer may preferably include ZnS(O, OH). The buffer layer does not contain harmful Cd, unlike a CdS buffer layer, and is thus an enhancement from an environmental aspect, and it can form a thin layer.

Then, the buffer layer is manufactured (formed) on the substrate with the light absorbing layer by washing and drying the substrate.

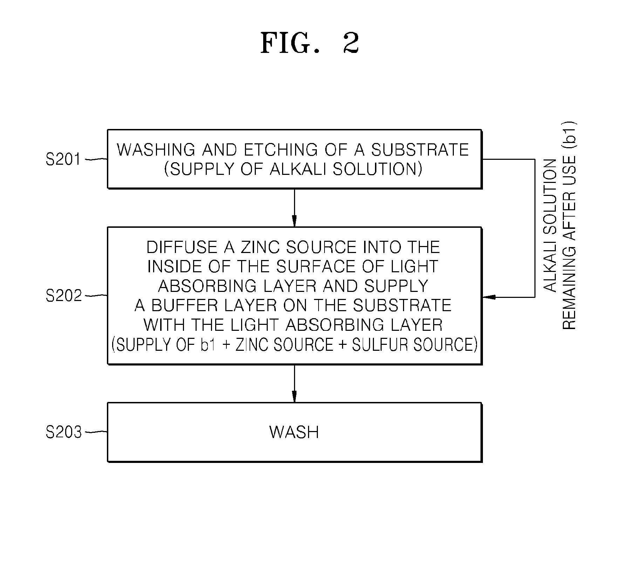

FIG. 2 is a flowchart illustrating a method of manufacturing a buffer layer for a thin film solar cell.

Referring to FIG. 2, in a modified example of the manufacturing method according to FIG. 2, a buffer layer for a thin film solar cell may be formed via a cascade method wherein diffusing a zinc source to the inside of a surface of a light absorbing layer and forming a buffer layer on a substrate with the light absorbing layer are performed in one bath; and the alkaline solution remaining after the use in washing and etching of the substrate is re-supplied to the bath and washed therein.

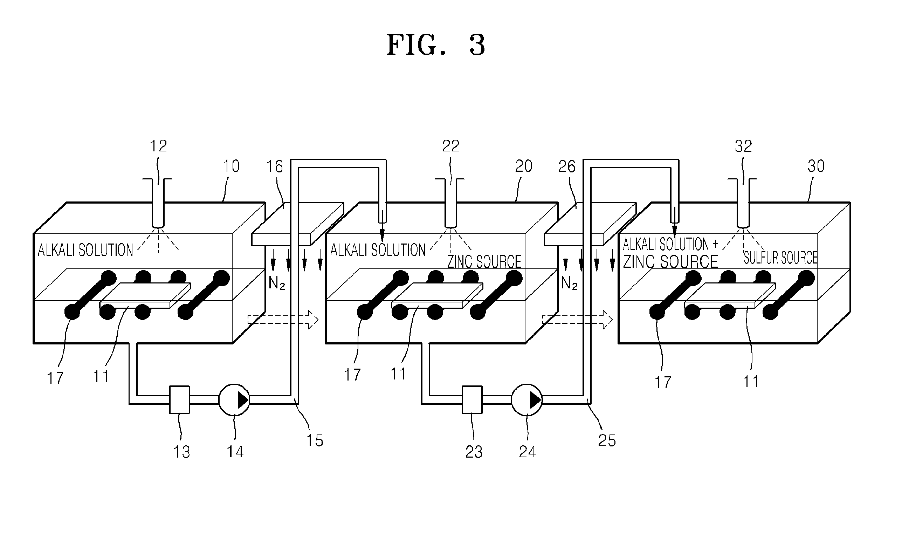

In another aspect, FIG. 3 is a schematic diagram illustrating a manufacturing device for forming a buffer layer of a thin film solar cell, according to an embodiment of the present invention. The manufacturing device is a device used for forming a buffer layer of a thin film solar cell via a cascade method.

In the present disclosure, "cascade method" refers to "a method wherein a material introduced initially can be recycled continuously in subsequent acts". The method includes not only a continuous reuse of the material remaining after the use in the previous act but also rendering an additional function by supplying an additional material according to its subsequent acts.

The device for forming a buffer layer of a thin film solar cell via a cascade method will be explained herein with reference to FIG. 3.

Referring to FIG. 3, first, washing and etching of a substrate 11, on which a light absorbing layer is formed, may preferably be carried out using an alkaline solution in a first bath 10. More specifically, the substrate 11, on which the light absorbing layer is formed is disposed inside the first bath 10. An alkaline solution is supplied onto the substrate 11, on which the light absorbing layer is formed, from a first supply device 12 in the upper part of the first bath 10 to thereby perform washing and etching of the substrate 11 inside the first bath 10. The alkaline solution includes an ammonia compound, for example, ammonia or an aqueous ammonia solution (NH$_4$OH). The alkaline solution used in the first bath preferably has a concentration of the alkali compound present of about 1 M to about 5 M, more preferably about 1.0 M to about 5.0 M, preferably about 2.0 M to about 3.5 M. The alkaline solution in the second and third baths also has a concentration in the mixed solutions prepared within the above ranges.

The first supply device 12 includes a tank which temporarily stores the alkaline solution and a pipe. During the above process, there is generated a solution remaining after the use in the first bath 10. The solution remaining after the use in the first bath 10 may preferably include the alkaline solution and a small amount of impurities. The solution remaining after the use in the first bath 10 may preferably be discharged into a first connecting device 15 through the lower part of the first bath 10.

The first connecting device preferably includes a first filtration part for filtrating a solution remaining after the use in the first bath, and a first pump for reintroducing the solution remaining after the use in the first bath into the second bath. The solution remaining after the use in the first bath 10 is filtered by a first filtration part 13 connected to the first connecting device 15, and the solution remaining is mostly the alkaline solution. The alkaline solution is supplied from the first bath 10 to a second bath 20 via a first pump 14 connected to the first connecting device 15.

The substrate 11, on which the light absorbing layer is formed, may preferably move horizontally from the first bath 10 to the second bath 20. The method to be used preferably includes a roll-to-roll method, in which the substrate moves by a roll (or rolls) 17 installed beneath the substrate 11, on which the light absorbing layer is formed. However, any suitable method known to one of ordinary skill in the art which can horizontally move the substrate 11, on which the light absorbing layer is formed, may be used.

Then, diffusing the zinc source to the inside of the surface of the light absorbing layer, i.e., preferably a zinc partial electrolyte (PE) treatment is carried out.

More specifically, the substrate 11 with the light absorbing layer moved out from the first bath 10 and is then positioned inside the second bath 20. A zinc source and the solution remaining after the use in the first bath 10, which is mostly the alkaline solution, are supplied to the substrate 11 with the light absorbing layer that is moved from the first bath 10. The alkaline solution may preferably include an ammonia compound, for example, an aqueous ammonia solution (NH$_4$OH). The zinc source may preferably include a zinc salt or a zinc compound, for example, an aqueous zinc sulfate (ZnSO4-7H$_2$O), etc. The solution remaining after the use in the first bath 10 is preferably supplied from the upper part of the second bath 20.

Further, the zinc source is preferably supplied from a second supply device 22 in the upper part of the second bath 20. The second supply device 22 includes a tank that temporarily stores the zinc source and a pipe. During the above process, there is also generated a solution remaining after the use in the second bath 20. The solution remaining after the use in the second bath 20 may preferably be discharged into a second connecting device 25 through the lower part of the second bath 20. The zinc source is supplied to the second bath at a concentration preferably of about 0.01 M to about 0.1 M, more preferably about 0.025 M to about 0.060 M, more preferably about 0.030 M to about 0.050 M. In an embodiment of the present invention the zinc source is preferably present in the mixed solution in the third bath at a concentration within these ranges.

In an embodiment of the present invetion the substrate is held in the second bath at a temperature below 70°C. For example, at a temperature between about 60°C to about 70°C. In an embodiment of the present invention this is for a period of between about 2 minutes and 10 minutes, preferably between about 3 minutes and about 8 minutes.

The second connecting device includes a second filtration part for filtrating a solution remaining after the use in the second bath, and a second pump for reintroducing the solution remaining after the use in the second bath into the third bath. The solution remaining after the use in the second bath 20 is preferably filtered by a second filtration part 23 connected to the second connecting device 25, thereby mostly leaving (keeping) the alkaline solution and the zinc source. The alkaline solution and the zinc source are preferably supplied from the second bath 20 to a third bath 30 via a second pump 24 connected to the second connecting device 25.

The substrate 11, on which the light absorbing layer is formed, may preferably move horizontally from the second bath 20 to the third bath 30. The method of moving the substrate 11, on which the light absorbing layer is formed, is preferably the same as described above.

The process carried out in the second bath 20, i.e., the zinc PE treatment, enables the reuse of the solution remaining after the use in the first bath 10 in order to remove a metal material such as CuSe and oxides on the surface of the light absorbing layer, while sufficiently substituting and diffusing the newly supplied zinc source into the inside of the surface of the light absorbing layer, thereby filling in PN junctions and Cu vacancies.

Then, the buffer layer is preferably formed on the light absorbing layer on the substrate via Chemical Bath Deposition (CBD) in the third bath.

More specifically, the substrate 11 moved from the second bath 20, on which the light absorbing layer is formed, is positioned inside the third bath 30. A sulfur source and the solution remaining after the use in the second bath 20, which is mostly the alkaline solution and the zinc source, are supplied to the substrate 11 with the light absorbing layer that is moved herein from the second bath 20. The alkaline solution and the zinc source are the same as described above. The sulfur source may preferably include a urea-based compound, for example, a thiourea. The sulfur source is supplied to the third bath at a concentration such that preferably the concentration in the mixed solution is about 0.2 M to about 1.3 M, more preferably about 0.35 M to about 1.0 M, more preferably about 0.45 M to about 0.75 M.

The solution remaining after the use in the second bath 20 is preferably supplied from the upper part of the third bath 30. Further, a sulfur source is preferably supplied from a third supply device 32 in the upper part of the third bath 30. The third supply device 32 preferably includes a tank which temporarily stores the sulfur source and a pipe. By the process, a buffer layer is formed on the substrate with the light absorbing layer.

Also, the manufacturing device further preferably includes a first blocking device 16 and a second blocking device 20 provided between the first bath 10 and the second bath 20, and the second bath 20 and the third bath 30 to prevent the flow of the solutions, respectively.

The first blocking device 16 and the second blocking device 26 may preferably both spray nitrogen gas or air. For example, the first blocking device 16 and the second blocking device 26 spray nitrogen gas or air, respectively. The first blocking device 16 and the second blocking device 26 can retain the solution and gas fumes inside the first bath 10 and the second bath 20 from being released to the outside due to the power of the gas spray. For example, the first blocking device 16 and the second blocking device 26 may preferably be prepared in the form of an air curtain or air shower.

The process carried out in the third bath 30, i.e., the forming of the buffer layer on the light absorbing layer, can fully remove impurities on the surface of the light absorbing layer by reusing the solution remaining after the use in the second bath 20, which is mostly the alkaline solution and the zinc source. The process can also sufficiently supply the zinc source to the vacancy region near the surface of the light absorbing layer, thereby uniformly diffusing and distributing the zinc source into the inside of the surface of the light absorbing layer.

Accordingly, the process enables a band alignment characteristic with a wide band gap between the light absorbing layer and the transparent electrode layer. Thus, the process can improve the electrical characteristics (e.g., $V_{oc}$) of a thin film solar cell including a buffer layer.

In another aspect of the present disclosure, there is provided a thin film solar cell including a buffer layer manufactured by the method described above.

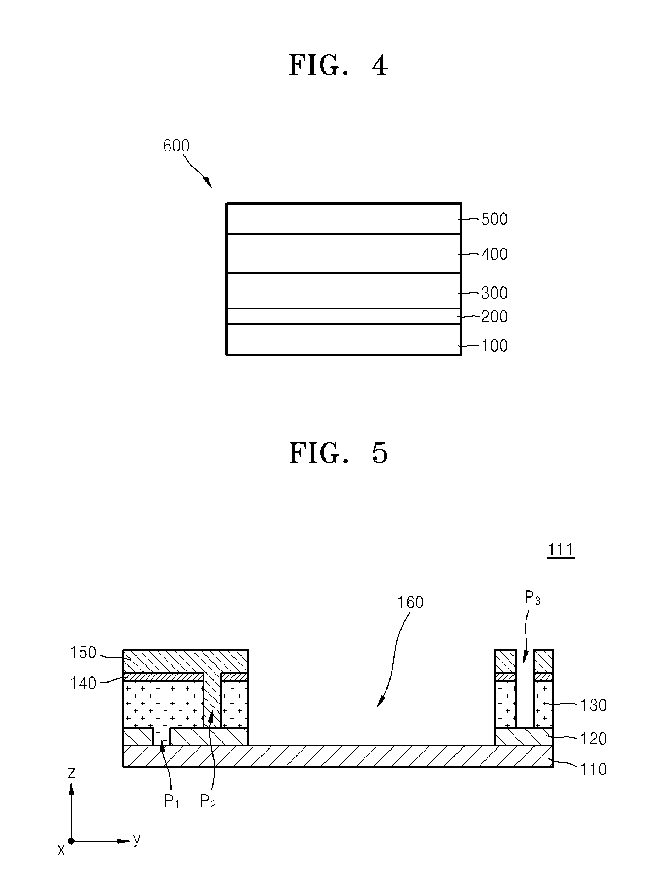

FIG. 4 and FIG. 5 respectively show a schematic cross-sectional view illustrating thin film solar cells 600 and 111 according to embodiments of the present invention.

Referring to FIG. 4 and FIG. 5, the thin film solar cells 600 and 111 respectively include substrates 100 and 110, backside electrode layers 200 and 120 formed on the substrates 100 and 110, light absorbing layers 300 and 130 formed on the backside electrode layers 200 and 120, buffer layers 400 and 140 formed on the light absorbing layers 300 and 130, and transparent electrode layers 500 and 150 formed on the buffer layers 400 and 140.

First, the substrates 100 and 110 may preferably be formed using a glass or polymer with excellent (e.g. high) light transmittance. For example, the glass may preferably be soda-lime glass or high strained point soda glass, and the polymer may preferably include polyimide but they are not limited thereto. In addition, the glass substrate may preferably be formed using a reinforced glass with low iron content to increase the transmittance rate of sunlight as well as to protect the internal elements of the substrate from external shock, etc. In particular, a soda-lime glass with low iron content is desired because sodium (Na) ions can be eluted out of the soda-lime glass during a high temperature process at 500°C or above, thereby further improving the efficiency of the light absorbing layer 300.

The backside electrode layers 200 and 120 may preferably be formed using a metal material having excellent (e.g. high) conductivity and light reflectivity, such as molybdenum (Mo), aluminum (Al), or copper (Cu), to collect charges formed by a photoelectric effect, and reflect the light transmitted through the light absorbing layers 300 and 130 so that it can be reabsorbed. In particular, the backside electrode layers 200 and 120 may preferably include Mo considering its high conductivity, ohmic contact with the light absorbing layers 300 and 130, and stability at a high temperature in a selenium (Se) atmosphere.

The backside electrode layers 200 and 120 may preferably be formed by coating a conductive paste on the substrate 100 and 110 followed by heat treatment, or other plating methods available. For example, the backside electrode layers 200 and 120 may preferably be formed by sputtering using a Mo target.

The backside electrode layers 200 and 120 may preferably have a thickness of about 200 nm to about 500 nm. For example, the backside electrode layers 200 and 120 may be divided into a plurality of regions (layer segments) by a first separation groove (P1). The first separation groove (P1) may be a groove formed in parallel with a direction of the substrates 100 and 110.

The first separation groove (P1) may be formed by first forming the backside electrode layers 200 and 120 on the substrates 100 and 110 and then dividing the backside electrode layers 200 and 120 by a first patterning into a plurality of regions. The first patterning may be, for example, performed by laser scribing. During the laser scribing, part of the backside electrode layers 200 and 120 is evaporated by laser irradiation on the substrates 100 and 110 from a lower part of the substrates 100 and 110, and the first separation groove (P1) (which divides the backside electrode layers 200 and 120 into a plurality of regions at regular intervals) is formed by laser scribing.

The backside electrode layers 200 and 120 may be doped with alkali ions, such as Na. For example, during the growth of the light absorbing layers 300 and 130, the alkali ions doped on the backside electrode layers 200 and 120 are introduced into the light absorbing layers 300 and 130, thereby producing a positive structural effect on the light absorbing layers 300 and 130 and improving the conductivity thereof. As such, the open voltage ($V_{oc}$) of the thin film solar cells 600 and 111 can be increased to thereby improve the efficiency of the thin film solar cells 600 and 111.

Furthermore, the backside electrode layers 200 and 120 may be formed as multiple layers in themselves to secure resistance characteristics of the backside electrode layers 200 and 120 as well as their adherence to the substrates 100 and 110.

The light absorbing layers 300 and 130 may be a P-type conductive layer by including $Cu(In,Ga)(Se,S)_2$ compounds substituted with S or a Cu-In-Ga-Se(CIGS)-based compound not substituted with S, and may absorb sunlight. The light absorbing layers 300 and 130 may be formed to have a thickness of about 0.7 $\mu$m to about 2 $\mu$m, and also formed within the first separation groove P1 that divides the backside electrode layers 200 and 120.

The light absorbing layers 300 and 130 may be formed by a co-evaporation method in which Cu, In, Ga, Se, etc., are added into a small electric furnace installed inside a vacuum chamber and heated therein, or a sputtering/selenization method in which a CIGS-based metal precursor film is formed on the backside electrode layers 200 and 120 by using a Cu target, an In target, and a Ga target, and then heat treating in an $H_2Se$ gas atmosphere to allow the metal precursor film to react with Se, thereby forming the light absorbing layers 300 and 130. Furthermore, the light absorbing layers 300 and 130 may be formed by an electro-deposition method, a metal-organic chemical vapor deposition method (MOCVD), etc.

The buffer layers 400 and 140 reduce both a band gap between the light absorbing layers 300 and 130 of a P-type and the transparent electrode layers 500 and 150 of an N-type and a recombination between electrons and holes that may occur at the interface with the transparent electrode layers 500 and 150. The buffer layers 400 and 140 may be formed by CBD, atomic layer deposition (ALD), ion lay gas reaction (ILGAR), etc. The buffer layers 400 and 140 may be formed of ZnS, ZnS(O, OH), $Zn_xMg_{1-x}O$, etc.

The light absorbing layers 300 and 130 and the buffer layers 400 and 140 may be divided into a plurality of regions by a second separation groove (P2). The second separation groove (P2) may be formed in parallel with the first separation groove (P1) at a different location from the first separation groove (P1), and the upper side of the backside electrode layers 200 and 120 is exposed to the outside by the second separation groove (P2).

After forming the light absorbing layers 300 and 130 and the buffer layers 400 and 140, the second separation groove (P2) is formed by performing the second patterning. The second patterning may be performed, for example, by mechanical scribing, wherein a sharp device such as a needle is moved in parallel with the first separation groove (P1) at a position separated from the first separation groove (P1) to thereby form the second separation groove (P2). However, the present invention is not limited thereto, and a laser may also be used.

The second patterning divides the light absorbing layers 300 and 130 into a plurality of regions, and the second separation groove (P2) formed by the second patterning extends to the upper side of the backside electrode layers 200 and 120 to thereby expose the backside electrode layers 200 and 120 to the outside.

The transparent electrode layers 500 and 150 form a P-N junction with the light absorbing layers 300 and 130. Further, the transparent electrode layers 500 and 150 are comprised of (e.g., consist of) transparent conductive materials, such as ZnO:B, ITO, or IZO, and trap charges formed by a photoelectric effect. The transparent electrode layers 500 and 150 may be formed by MOCVD, low pressure chemical vapor deposition (LPCVD), or sputtering.

Further, although not shown in the figures, the upper side of the transparent electrode layers 500 and 150 may be subjected to texturing in order to reduce the reflection of sunlight incident thereon and increase the light absorption by the light absorbing layers 300 and 130.

The transparent electrode layers 500 and 150 may be also formed within the second separation groove (P2), and by contacting the backside electrode layers 200 and 120 exposed by the second separation groove (P2), the transparent electrode layers 500 and 150 can be electrically connected to the light absorbing layers 300 and 130, which are divided into a plurality of regions by the second separation groove (P2).

The transparent electrode layers 500 and 150 may be divided into a plurality of regions by a third separation groove (P3) formed in a location different from those of the first separation groove (P1) and the second separation groove (P2). The third separation groove (P3) may be formed in parallel with the first separation groove (P1) and the second separation groove (P2) and may extend to the upper face of the backside electrode layers 200 and 120. The third separation groove (P3) may be filled with an insulation material, such as air.

The third separation groove (P3) may be formed by performing a third patterning. The third patterning may be performed by mechanical scribing, and the third separation groove (P3) formed by the third patterning may extend to the upper side of the backside electrode layers 200 and 120, thereby forming a plurality of photoelectric conversion units. In addition, the third separation groove (P3) may be filled with air, thus forming an insulation layer.

In certain embodiments, the upper side of the transparent electrode layers 500 and 150 may have a textured surface. Texturing refers to forming a rugged pattern on the upper side by a physical or chemical method. When the surface of the transparent electrode layers 500 and 150 is rough due to texturing, the reflection rate of incident light thereon decreases, thereby increasing the amount of trapped light. Accordingly, the texturing has an effect of reducing optical loss.

Hereinafter, the present disclosure is further illustrated by the following examples and comparative examples. However, it shall be understood that these examples are only used to specifically set forth the present disclosure, and they are not provided to be limiting in any form.

**[Examples]_**

**Example 1: Manufacture of a thin film solar cell**

A soda lime glass substrate with a thickness of about 1 mm sheathed thereon with an about 500 $\mu$m thick Mo backside electrode layer was prepared. A CuGa target and an In target were respectively sputtered on the soda lime glass substrate sheathed thereon with an Mo backside electrode layer, and the soda lime glass substrate was then heat-treated in an $H_2Se$ and $H_2S$ atmosphere at 400°C for 20 minutes and at 550°C for 60 minutes, respectively, thereby forming a light absorbing layer having a composition of $Cu(In,Ga)(Se,S)_2$.

A buffer layer was formed on the light absorbing layer using CBD in a cascade method as follows:

The substrate was washed and etched by supplying 2.5 M $NH_4OH$ through a first supply device to the upper part of the substrate disposed in a first bath, on which a light absorbing layer is formed.

Then, the substrate was moved from the first bath to a second bath via a roll-to-roll method. The solution remaining after the use in washing and etching was filtered by a first filter disposed in the first connecting device connected to a lower part of the first bath, and an $NH_4OH$ solution was obtained as a result. The $NH_4OH$ solution was then supplied to an upper part of the second bath using a pump. At the same time, $ZnSO_4 \cdot 7H_2O$ was supplied from a second supply device in the upper part of the second bath. The surface and inside of the light absorbing layer was washed further at 65°C for 5 minutes with 2.5 M $NH_4OH$ supplied by the second bath after filtration and 0.04 M $ZnSO_4 \cdot 7H_2O$ freshly supplied by the second bath while diffusing and substituting a zinc source to the inside of the surface of the light absorbing layer.

Then, the substrate was moved from the second bath to a third bath via a roll-to-roll method. The $NH_4OH$ and $ZnSO_4 \cdot 7H_2O$ solutions remaining after the use in the second bath for diffusing the zinc source into the inside of the surface of the light absorbing layer were removed of their impurities by using a second filter in a second connecting device connected to the lower part of the third bath. As a result, $NH_4OH$ and $ZnSO_4 \cdot 7H_2O$ solutions supplied from the second bath to the third bath after filtration were obtained. The $NH_4OH$ and $ZnSO_4 \cdot 7H_2O$ solutions were supplied to an upper part of the third bath using a pump. At the same time, $SC(NH_2)_2$ was supplied from the third supply device in the third bath. Here, the concentration for each of $NH_4OH$, $ZnSO_4 \cdot 7H_2O$, and $SC(NH_2)_2$ in the mixed solution contained in the third bath was 2.5 M, 0.04 M, and 0.55 M. The substrate, on which the light absorbing layer was formed, was immersed into the mixed solution, reacted at 65°C for 10 minutes and thus a buffer layer with a thickness of 5 A on the light absorbing layer on the substrate was finally obtained.

Then, a ZnO transparent electrode layer was formed on the buffer layer by an MOCVD method, thereby completing the manufacture of a thin film solar cell.

## Comparative Example 1: Manufacture of a thin film solar cell

A soda lime glass substrate with a thickness of about 1 mm sheathed thereon with an about 500 $\mu$m thick Mo backside electrode layer was prepared. A CuGa target and an In target were respectively sputtered on the soda lime glass substrate sheathed thereon with an Mo backside electrode layer, and the soda lime glass substrate was then heat-treated in an $H_2Se$ and $H_2S$ atmosphere at 400°C for 20 minutes and at 550°C for 60 minutes, respectively, thereby forming a light absorbing layer having a composition of $Cu(In,Ga)(Se,S)_2$.

A buffer layer was formed on the light absorbing layer as follows:

A substrate, on which the light absorbing layer is formed, was disposed inside the bath. Inside the bath, $NH_4OH$, $ZnSO_4.7H_2O$, and $SC(NH_2)_2$ solutions with a respective concentration of 2.5 M, 0.04 M, and 0.55 M were prepared therein. The substrate, on which the light absorbing layer is formed, was immersed into the mixed solution, and allowed to react at 65°C for 15 minutes to form a buffer layer with a thickness of about 5 A on the light absorbing layer on the substrate.

Then, a ZnO transparent electrode layer was formed on the buffer layer by an MOCVD method, thereby completing the manufacture of a thin film solar cell.

## Comparative Example 2: Manufacture of a thin film solar cell

A soda lime glass substrate with a thickness of about 1 mm sheathed thereon with an about 500 $\mu$m thick Mo backside electrode layer was prepared. A CuGa target and an In target were respectively sputtered on the soda lime glass substrate sheathed thereon with an Mo backside electrode layer, and the soda lime glass substrate was then heat-treated in an $H_2Se$ and $H_2S$ atmosphere at 400°C for 20 minutes and at 550°C for 60 minutes, respectively, thereby forming a light absorbing layer having a composition of $Cu(In,Ga)(Se,S)_2$.

A buffer layer was formed on the light absorbing layer using Zn PE (partial electrolyte) as follows:

A substrate, on which the light absorbing layer is formed, was disposed inside the bath. Inside the bath, $NH_4OH$ and $ZnSO_4 \cdot 7H_2O$ solutions with a respective concentration of 2.5 M and 0.04 M were prepared therein. The substrate, on which the light absorbing layer is formed, was immersed into the mixed solution, and allowed to react at 65°C for 15 minutes to form a buffer layer with a thickness of about 5 A on the light absorbing layer on the substrate.

Then, a ZnO transparent electrode layer was formed on the buffer layer by an MOCVD method, thereby completing the manufacture of a thin film solar cell.

## Evaluation Example 1: Evaluation of electrical characteristics

An optical current and voltage was measured for the thin film solar cells manufactured according to Example 1 and Comparative Examples 1 and 2. Current density ($J_{sc}$), open circuit voltage ($V_{oc}$), and fill factor (FF) were calculated from the measured optical current curves, and the efficiency ($\eta$) of the thin film solar cells manufactured according to Example 1 and Comparative Examples 1 and 2 were calculated using Equation 1. The results are shown in Table 1 below. In Equation 1, $J_{sc}$ represents the current density, $V_{oc}$ represents the open circuit voltage, FF represents the fill factor, $P_{input}$ represents the input light energy, and $\eta$ represents the efficiency of the thin film solar cells.

A xenon lamp was used as a light source, and the solar condition of the xenon lamp was calibrated using a standard solar cell (Frunhofer Institute Solare

Engeriessysysteme, Certificate No. C-ISE369, Type of material: Mono-Si+KG filter), and 1 sun (a standard condition for measuring solar cell characteristics wherein light intensity is 100 mW/cm$^2$, and solar spectrum is AM 1.5G) was irradiated and optical current and voltage were measured at a power density of 100 mW/cm$^2$.

Equation 1

$$\eta(\%) = [(V_{oc} \times J_{sc} \times FF)/ P_{input}] \times 100$$

Table 1

| Category | Current Density ($J_{sc}$) [Am cm$^{-2}$] | Open circuit voltage ($V_{oc}$) [V] | Fill factor (FF) [%] | Efficiency ($\eta$) [%] |
|---|---|---|---|---|
| Example 1 | 1.03 | 1.02 | 1.02 | 1.07 |
| Comparative Example 1 | 1 | 1 | 1 | 1 |
| Comparative Example 2 | 0.98 | 0.99 | 0.99 | 0.97 |

As shown in Table 1 above, the current density, open circuit voltage, fill factor, and efficiency of a thin film solar cell manufactured according to Example 1 were all superior to those manufactured according to Comparative Examples 1 and 2. The above results confirmed that the electrical characteristics of a thin film solar cell manufactured according to Example 1 were much improved than those manufactured according to Comparative Examples 1 and 2.

It should be understood that the example embodiments described herein should be considered in a descriptive sense only and not for purposes of limitation. Descriptions of features or aspects within each embodiment should typically be considered as being available for other similar features or aspects in other embodiments. While this invention has been described in connection with what is presently considered to be practical embodiments, it is to be understood that the invention is not limited to the disclosed embodiments, but, on the contrary, is intended to cover various modifications and equivalent arrangements included within the scope of the appended claims and equivalents thereof.

**Claims**

1. A method of manufacturing a thin film solar cell, the method comprising:

   supplying an alkaline solution to a substrate on which a light absorbing layer is formed disposed inside a first bath ;
   washing and etching the substrate inside the first bath;
   moving the substrate to a second bath;
   supplying a zinc source and a solution that remained in the first bath after the supplying of the alkaline solution and the washing and etching of the substrate, to the substrate disposed inside the second bath;
   diffusing the zinc source to inside of the light absorbing layer through a surface of the light absorbing layer;
   moving the substrate to a third bath;
   supplying a sulfur source and a mixed solution comprising a solution that remained in the second bath after the supplying of the zinc source and the diffusing of the zinc source, to the substrate disposed inside the third bath; and
   forming a buffer layer on the light absorbing layer.

2. The method according to claim 1, wherein the alkaline solution comprises an ammonia compound.

3. The method according to claim 1 or claim 2, wherein the zinc source comprises a zinc salt or a zinc compound.

4. The method according to any of claims 1 to 4, wherein the sulfur source comprises a thiourea-based compound.

5. The method according to claim 1, wherein, in the forming of the buffer layer on the substrate with the light absorbing layer, the mixed solution remaining in the second bath after the supplying of the zinc source and the diffusing of the zinc source comprises the alkaline solution and the zinc source.

6. The method according to any of claims 1 to 5, wherein, in the forming of the buffer layer on the substrate with the light absorbing layer, the sulfur source is supplied to give a concentration of about 0.2 M to about 1.3 M in the mixed solution, and the mixed solution comprises about 1 M to about 5 M of the alkaline solution, and about 0.01 M to about 0.1 M of the zinc source.

7. The method according to any of claims 1 to 6, wherein, the forming of the buffer layer on the light absorbing layer, comprises immersing the substrate with the light absorbing layer into the mixed solution, followed by heating at a temperature below 70°C, optionally between about 60°C to about 70°C.

8. The method according to any of claims 1 to 7, wherein the buffer layer formed on the substrate with the light absorbing layer comprises ZnS(O, OH).

9. A device of manufacturing a thin film solar cell, the device comprising:

a first bath configured to supply an alkaline solution to a substrate disposed therein;
a second bath configured to supply a zinc source and a solution from the first bath to the substrate moved thereto from the first bath;
a third bath configured to supply a sulfur source and a solution from the second bath to the substrate moved thereto from the second bath;
a first connecting device connected to the first bath and the second bath, and configured to collect the solution in the first bath, and to supply the solution in the first bath to the second bath; and
a second connecting device connected to the second bath and the third bath, and configured to collect the solution in the second bath, and to supply the solution in the second bath to the third bath.

10. The device according to claim 9, wherein the second bath is configured to diffuse the zinc source to inside of the light absorbing layer through the surface of the light absorbing layer in the second bath.

11. The device according to claim 9 or claim 10, wherein the third bath is configured to form the buffer layer on the light absorbing layer on the substrate via Chemical Bath Deposition (CBD).

12. The device according to any of claims 9 to 11, wherein the first connecting device comprises a first filtration part for filtrating the solution in the first bath, and a first pump for introducing the solution in the first bath into the second bath.

13. The device according to any of claims 9 to 12, wherein the second connecting device comprises a second filtration part for filtrating the solution in the second bath, and a second pump for introducing the solution in the second bath into the third bath.

14. The device according to any of claims 9 to 13, further comprising a first blocking device between the first bath and the second bath, and a second blocking device between the second bath and the third bath, the first blocking device and the second blocking device are configured to prevent the flow of the solutions, respectively.

15. A thin film solar cell comprising a buffer layer formed according to the method of any of claims 1 to 8.

# FIG. 1

S101

WASHING
AND ETCHING OF A SUBSTRATE
(SUPPLY OF ALKALI SOLUTION)

ALKALI SOLUTION REMAINING AFTER USE (a1)

S102

DIFFUSE A ZINC
SOURCE INTO THE INSIDE OF THE
SURFACE OF LIGHT ABSORBING LAYER
(SUPPLY OF a1 + ZINC SOURCE)

ALKALI SOLUTION REMAINING AFTER USE & ZINC SOURCE (a2)

S103

SUPPLY A BUFFER
LAYER ON THE SUBSTRATE
WITH THE LIGHT ABSORBING LAYER
(SUPPLY OF a2 + SULFUR SOURCE)

WASH

# FIG. 2

```
S201 ┌─────────────────────────────────────────┐
─────┤  WASHING AND ETCHING OF A SUBSTRATE      │
     │       (SUPPLY OF ALKALI SOLUTION)        │
     └─────────────────────────────────────────┘
                        │
                        ▼
S202 ┌─────────────────────────────────────────┐
─────┤       DIFFUSE A ZINC SOURCE INTO THE     │
     │       INSIDE OF THE SURFACE OF LIGHT     │
     │       ABSORBING LAYER AND SUPPLY         │
     │    A BUFFER LAYER ON THE SUBSTRATE       │
     │    WITH THE LIGHT ABSORBING LAYER        │
     │ (SUPPLY OF b1 + ZINC SOURCE + SULFUR SOURCE) │
     └─────────────────────────────────────────┘
                        │
                        ▼
S203 ┌─────────────────────────────────────────┐
─────┤                 WASH                     │
     └─────────────────────────────────────────┘
```

ALKALI SOLUTION
REMAINING AFTER USE (b1)

# FIG. 3

EP 2 804 220 A2

# FIG. 4

600

500

400

300

200

100

# FIG. 5

111

150

140

160

P₃

130

120

110

P₁  P₂

z

y

x